## Europäisches Patentamt

## European Patent Office

## Office européen des brevets

(19)

(11) Numéro de publication: **0 170 544**
**B1**

## FASCICULE DE BREVET EUROPÉEN

(12)

(45) Date de publication du fascicule du brevet:
23.08.89

(51) Int. Cl.⁴: **H 01 L 21/60, H 01 L 23/52**

(21) Numéro de dépôt: 85401136.8

(22) Date de dépôt: 10.06.85

(54) Procédé d'autopositionnement d'une ligne d'interconnexion sur un trou de contact électrique d'un circuit intégré.

(30) Priorité: 14.06.84 FR 8409313

(43) Date de publication de la demande:
05.02.86 Bulletin 86/6

(45) Mention de la délivrance du brevet:
23.08.89 Bulletin 89/34

(84) Etats contractants désignés:
BE CH DE GB IT LI NL

(56) Documents cité:
EP-A-0 002 798
EP-A-0 070 737
EP-A-0 119 497
EP-A-0 123 309
US-A-4 361 599
US-A-4 392 298

TECHNICAL DIGEST OF THE INTERNATIONAL
ELECTRON DEVICE MEETING, Washington, D.C.,
décembre 1981, pages 54-57, IEEE, New York, uS;
P.A. GARGINI et al.: "WOS: Low resistance self-
aligned source, drain and gate transistors"

(73) Titulaire: **COMMISSARIAT A L'ENERGIE
ATOMIQUE**, 31/33, rue de la Fédération, F-75015
Paris (FR)

(72) Inventeur: **Hartmann, Joel**, 13, rue de la Balmette,
F-38640 Claix (FR)

(74) Mandataire: **Mongrédien, André**, c/o BREVATOME
25, rue de Ponthieu, F-75008 Paris (FR)

EP 0 170 544 B1

## Description

Le présente invention a pour objet un procédé d'autopositionnement d'une ligne d'interconnexion sur un trou de contact électrique d'un circuit intégré. Ce procédé d'autopositionnement est utilisable, en particulier, dans les procédés de fabrication de circuits intégrés MOS (Métal-Oxyde-Semiconducteur).

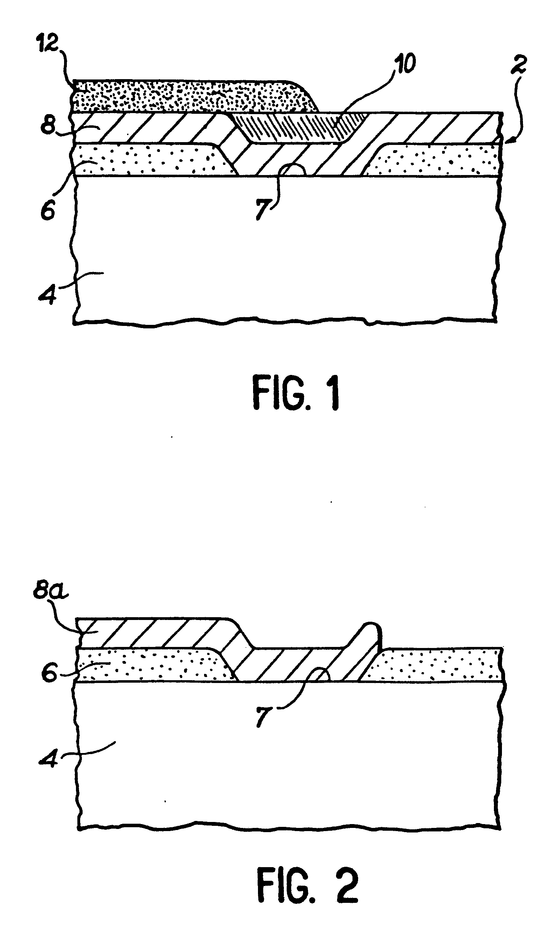

Sur les figures 1 et 2, on a représenté en coupe, selon l'art antérieur, les étapes d'un procédé d'autopositionnement d'une ligne d'interconnexion sur un trou de contact électrique d'un circuit intégré. Le circuit intégré, portant la référence générale 2, comprend une zone active 4, semiconductrice dopée, correspondant par exemple à la source ou au drain d'un transistor MOS, devant être connectée électriquement à une autre zone active (non représentée) du circuit intégré. Cette zone active 4 est recouverte d'une couche d'oxyde 6 dans laquelle on réalise le trou de contact électrique 7 de cette zone active 4, en gravant la couche d'oxyde 6 par attaque chimique à travers un masque approprié disposé sur cette couche. L'interconnexion de la zone active 4 et de l'autre zone active du circuit intégré est réalisée en recouvrant l'ensemble du circuit intégré d'une couche conductrice 8, généralement en aluminium, puis en gravant cette couche. Cette couche 8 étant d'épaisseur constante, forme un creux au-dessus du trou de contact électrique 7.

Pour réaliser ta ligne d'interconnexion 8a (visible sur la figure 2) dans la couche conductrice 8, on dépose sur cette couche conductrice une couche de résine 10 qui est ensuite gravée de manière à ne subsister que dans te creux situé au-dessus du trou de contact électrique 7. On réalise ensuite, dans une couche de résine 12, un masque représentant l'image de la ligne d'interconnexion. La couche conductrice 8 est ensuite gravée, à travers le masque, par exemple de façon isotrope par une simple attaque chimique ou de façon anisotrope par un plasma contenant des composés tels que CCl$_4$ Les couches de résines 10 et 12 sont ensuite éliminées. On obtient alors la ligne d'interconnexion 8a représentée en coupe sur la figure 2.

Ce procédé, décrit dans la demande de brevet EP-A-0 091 870 déposée au nom de la demanderesse, permet de réaliser des lignes d'interconnexion sur un trou de contact électrique sans que ces lignes d'interconnexion ne débordent du trou de contact électrique. Il permet donc de réaliser des lignes d'interconnexion dont la largeur n'est pas plus importante que le diamètre du trou de contact électrique ce qui permet d'augmenter la densité d'intégration par rapport aux autres procédés connus.

Cependant, dans ce procédé, le résidu de la première couche de résine 10 présente une faible épaisseur résistant difficilement à la gravure lors de la réalisation de la ligne d'interconnexion.

Par ailleurs, la zone active et la ligne d'interconnexion sont en contact direct, et des atomes métalliques, par exemple d'aluminium lorsque la couche métallique est réalisée en un tel matériau, peuvent, lors des traitements thermiques ultérieurs, diffuser dans la zone active entraînant ainsi des courants de fuites qui peuvent être nuisibles au bon fonctionnement des circuits intégrés.

La présente invention a justement pour objet un procédé d'autopositionnement d'une ligne d'interconnexion sur un trou de contact électrique d'un circuit intégré permettant notamment de remédier aux différents inconvénients donnés ci-dessus.

De façon plus précise, l'invention a pour objet un procédé d'autopositionnement d'une ligne d'interconnexion sur un trou de contact électrique d'un circuit intégré, caractérisé en ce que, le trou de contact électrique étant réalisé dans une couche isolante, on effectue les opérations successives suivantes:

(a) - dépôt sur l'ensemble du circuit intégré d'une première couche conductrice,

(b) - dépôt sur la première couche conductrice d'un matériau de remplissage servant à combler le trou de contact, la surface de ce matériau étant sensiblement plane,

(c) - réalisation d'une gravure anisotrope du matériau de remplissage de façon à mettre à nu les parties de la première couche conductrice situées en dehors du trou de contact et à ne garder de ce matériau de remplissage que la partie remplissant le trou de contact,

(d) - dépôt sur la structure obtenue d'une deuxième couche conductrice, dans laquelle sera réalisée la ligne d'interconnexion,

(e) - réalisation sur la deuxième couche conductrice d'un masque de résine servant à définir les dimensions de la ligne d'interconnexion,

(f) - élimination des parties de la deuxième et de la première couches conductrices dépourvues de masque, afin de réaliser la ligne d'interconnexion, et

(g) - élimination du masque.

Le rôle de la première couche conductrice est d'assurer de façon efficace une barrière de diffusion (c'est-à-dire s'opposant à la diffusion) des atomes de la ligne d'interconnexion dans la zone active à connecter, protégeant ainsi la zone active et donc les jonctions semi-conductrices sous-jacentes.

Par ailleurs, l'emploi d'un matériau remplissant totalement le trou de contact électrique permet, même si le masque de résine servant à définir la ligne d'interconnexion est désaligné par rapport au trou de contact, d'assurer dans tout ce trou de contact un contact électrique.

Selon un mode préféré de mise en oeuvre du procédé de l'invention, la première couche conductrice est un film métallique réalisé de préférence en un alliage de titane et de tungstène ou en tungstène seul. L'emploi d'un tel matériau permet, compte tenu de sa résistivité relativement faible, d'obtenir une résistance de contact entre la ligne d'interconnexion et le trou de contact électrique relativement faible.

Selon un autre mode préféré de mise en oeuvre du procédé de l'invention, on réalise le dépôt de la première couche conductrice par un procédé de pulvérisation magnétron et le matériau de remplissage par un procédé de dépôt isotrope (LPCVD).

De façon avantageuse, ce matériau de remplissage est réalisé en silicium polycristallin.

Selon un autre mode préféré de mise en oeuvre du procédé de l'invention, ce matériau de remplissage présente une épaisseur supérieure à la demi-largeur du trou de contact électrique. Ceci permet d'assurer le remplissage complet du trou de contact.

Selon un autre mode préféré de mise en oeuvre du procédé de l'invention, on réalise l'étape (c) en déposant une couche de résine sur le matériau de remplissage et en gravant simultanément la couche de résine et le matériau de remplissage avec des vitesses d'attaque identiques pour la résine et ledit matériau de remplissage. Ceci permet de faire affleurer ce matériau de remplissage à la surface du trou de contact.

· Selon un autre mode préféré de mise en oeuvre du procédé de l'invention, l'étape (f) est réalisée au moyen d'une gravure sèche anisotrope.

D'autres caractéristiques et avantages de l'invention ressortiront mieux de la description qui va suivre, donnée à titre illustratif mais nullement limitatif, en référence aux figures annexées sur lesquelles:

- les figures 1 et 2, déjà décrites, représentent, schématiquement les étapes d'un procédé d'autopositionnement d'une ligne d'interconnexion sur un trou de contact d'un circuit intégré selon l'art antérieur,
- les figures 3 à 6, 9 et 10, représentent, schématiquement, les différentes étapes du procédé d'autopositionnement sur un trou de contact électrique d'une ligne d'interconnexion, conformément à l'invention, et
- les figures 7 à 8 représentent, schématiquement, une variante du procédé d'autopositionnement selon l'invention.

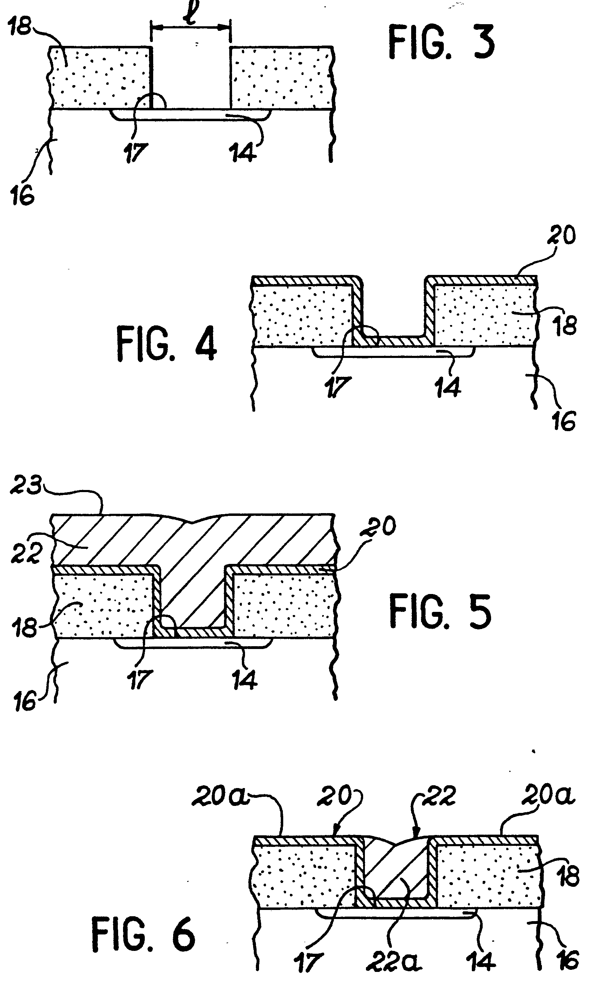

Sur la figure 3, on a représenté une partie d'un circuit intégré comprenant une zone active 14, semi-conductrice dopée, réalisée dans un substrat en silicium monocristallin 16 et correspondant par exemple à la source ou au drain d'un transistor MOS que l'on veut connecter électriquement à une autre zone active (non représentée) du circuit intégré. De façon classique, cette zone active 14 est recouverte d'une couche isolante 18, généralement réalisée en oxyde de silicium pouvant contenir 5 à 10 % de phosphore. Cette couche d'oxyde présente par exemple une épaisseur de 0,8 μm. Cette couche d'oxyde 18 est ensuite gravée, en utilisant un masque de résine réalisé par photolithographie sur cette couche, par exemple par une gravure anisotrope telle qu'une gravure ionique réactive avec $CHF_3$ de façon à réaliser le trou de contact électrique 17 de la zone active 14. Ce type de gravure permet d'obtenir un trou de contact présentant des bords sensiblement perpendiculaires à la surface du circuit intégré.

Après la réalisation du trou de contact électrique 17, on dépose sur l'ensemble du circuit intégré une première couche conductrice 20, comme représenté sur la figure 4. Cette première couche conductrice 20, présentant une épaisseur de 1 000 à 1 500 A (0,1 à 0,15 μm), peut être déposée par la technique de dépôt par pulvérisation magnétron ou d'évaporation sous vide.

Cette première couche conductrice 20 permet d'assurer un très bon contact électrique avec la zone active 14 du circuit intégré. De plus, cette couche 20 joue le rôle de barrière de diffusion, c'est-à-dire d'une barrière empêchant la diffusion des atomes du matériau constituant la ligne d'interconnexion à réaliser dans la zone active 14.

De façon avantageuse, cette couche conductrice 20 est réalisée en métal et en particulier en un alliage de titane et de tungstène ou en tungstène, ce qui permet d'obtenir une résistance de contact, entre la ligne d'interconnexion à réaliser et le trou de contact électrique 17, relativement faible, compte tenu de la résistivité faible de ce matériau.

Bien entendu, la première couche conductrice peut être réalisée en un autre métal que le tungstène ou l'alliage de titane et de tungstène, sa caractéristique principale étant d'assurer une barrière de diffusion efficace entre la ligne d'interconnexion à réaliser et la jonction semi-conductrice, situées sous le trou de contact électrique.

L'étape suivante du procédé, comme représenté sur la figure 5, consiste à déposer sur la première couche conductrice 20 un matériau de remplissage 22, réalisé par exemple en silicium polycristallin, servant à remplir complètement le trou de contact électrique 17 et à aplanir la topographie du circuit intégré au-dessus de ce trou de contact; il présente en conséquence une surface sensiblement plane 23. Ce matériau de remplissage 22 présente de préférence une épaisseur qui est supérieure à la demi-largeur 1/2 (figure 3) du trou de contact électrique 17; par exemple pour un trou de contact de 1 sur 1 μm, ce matériau 22 peut présenter une épaisseur allant de 7 000 à 10 000 Å (0,7 à 1 μm).

Le remplissage du trou de contact électrique 17 par le matériau 22 ainsi que l'obtention d'une surface plane 23 de ce matériau peut être obtenu au moyen d'un procédé de dépôt isotrope qui peut être réalisé, dans le cas d'un matériau de remplissage 22 en silicium polycristallin, par un procédé de dépôt chimique en phase vapeur à pression atmosphérique (CVD) ou à basse pression (LPCVD).

Il est à noter que le matériau de remplissage 22 n'est pas forcément conducteur; il peut notamment être isolant, sa caractéristique principale étant d'être déposé de façon isotrope et d'assurer un bon remplissage du trou de contact électrique.

L'étape suivante du procédé consiste, comme représenté sur la figure 6, à réaliser une gravure anisotrope du matériau de remplissage 22. Cette gravure est réalisée de façon à mettre à nu les parties 20a de la première couche conductrice situées en dehors du trou de contact électrique 17, et à ne garder de ce matériau de remplissage que la partie 22a remplissant ce trou de contact. Cette gravure doit donc présenter un caractère de sélectivité, de façon à ne graver que le matériau 22 et à s'arrêter dès la mise à nu des régions 20a de la première couche conductrice.

Une telle gravure peut être réalisée au moyen d'une gravure dite "pleine tranche", c'est-à-dire sans utilisation de masque, en utilisant par exemple une gravure ionique réactive contenant, dans le cas d'un matériau de remplissage 22 en silicium polycristallin, de l'hexafluorure de soufre comme agent d'attaque.

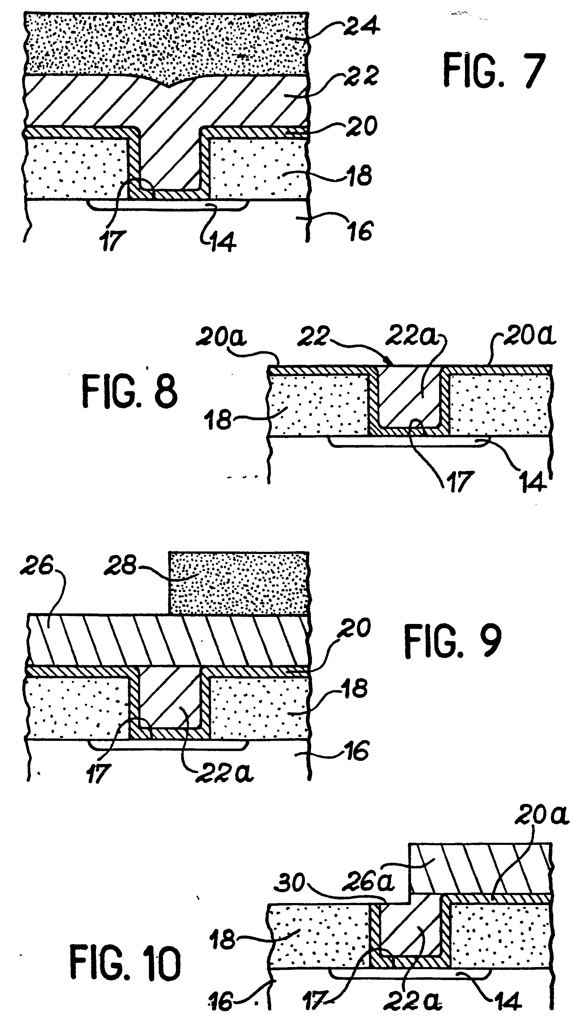

Selon l'invention, il est aussi possible de recourir à une technique de "planarisation" pour réaliser la gravure du matériau de remplissage 22 de façon à éliminer complètement les parties de ce matériau 22 situées au-dessus des parties 20a de la première couche conductri ce, se trouvant en dehors du trou de contact électrique 17. Cette technique est illustrée sur les figures 7 à 8.

Elle consiste, tout d'abord, à recouvrir le matériau de remplissage 22 d'une couche de résine 24 (figure 7), par un procédé d'étalement classique. Cette couche de résine 24, qui peut être réalisée en une résine couramment utilisée en photolitographie, présente par exemple une épaisseur de 1,5 μm à 2 μm. Après ce dépôt, on réalise une gravure anisotrope, et ce de façon simultanée, de la couche de résine 24 et du matériau de remplissage 22 avec des vitesses d'attaque identiques pour la résine et le matériau de remplissage 22. Lorsque le matériau de remplissage 22 est réalisé en silicium polycristallin, la gravure simultanée de la résine et du silicium peut par exemple être réalisée avec un procédé de gravure ionique réactive en utilisant comme agent d'attaque un mélange d'hexafluorure de soufre et d'oxygène ($SF_6 + O_2$). Comme précédemment, cette gravure présente un caractère de sélectivité, ce qui permet d'arrêter la gravure dès la mise à nu des régions 20a de la première couche conductrice 20 et de laisser le trou de contact électrique 17 complètement rempli du matériau 22 (figure 8).

Cette technique de "planarisation" permet d'obtenir une région 22a du matériau 22, comblant le trou de contact, présentant une surface plane (figure 8).

L'étape suivante du procédé consiste, comme représenté sur la figure 9, à déposer sur la structure obtenue (figure 6 ou figure 8) une deuxième couche conductrice 26 dans laquelle sera réalisée la ligne d'interconnexion. Cette couche conductrice 26 réalisée par exemple en aluminium présente une épaisseur allant de 500 à 1000 nm. Elle peut être obtenue par une technique de dépôt par pulvérisation magnétron ou bien par une technique d'évaporation sous vide.

Ensuite, on réalise sur la deuxième couche conductrice 26 un masque de résine 28 servant à définir les dimensions de la ligne d'interconnexion à réaliser. Ce masque de résine 28, qui peut être réalisé selon les procédés classiques de la microphotolithographie, représente l'image de la ligne d'interconnexion à réaliser.

Après réalisation du masque 28, on élimine les parties de la deuxième couche conductrice 26 dépourvue de masque afin de réaliser la ligne d'interconnexion 26a, comme représenté sur la figure 10. Ceci peut être réalisé en gravant la couche conductrice 26 par exemple par un procédé de gravure sèche anisotrope, utilisant par exemple du tétrachlorure de carbone lorsque cette couche conductrice 26 est réalisée en aluminium.

On élimine ensuite les parties de la première couche conductrice 20 dépourvues du masque 28. Ceci peut être réalisé lors de la même étape de gravure anisotrope que celle de la deuxième couche conductrice 26, cette gravure permettant de s'arrêter sélectivement au-dessus de la région 22a du matériau de remplissage 22, notamment en silicium polycristallin, remplissant le trou de contact électrique, et sur la couche d'isolant 18, notamment en oxyde de silicium, ayant servi à la formation du trou de contact électrique 17. Cette gravure de la première couche conductrice 20 est donc réalisée par le même procédé de gravure ionique réactive utilisant le tétrachlorure de carbone lorsque cette première couche conductrice est réalisée en un alliage de titane et de tungstène ou en tungstène.

La dernière étape du procédé consiste à éliminer le masque de résine 28, par exemple par attaque chimique. La figure 10 représente la structure finale après gravure de la ligne d'interconnexion et élimination de la résine.

Dans ce procédé, le contact électrique, entre la zone active 14 et la ligne d'interconnexion 26a est obtenu par l'intermédiaire de la région 20a restant de la première couche conductrice située au contact de la ligne d'interconnexion.

Le procédé selon l'invention permet, même si le masque de résine servant à la définition de la ligne d'interconnexion est désaligné par rapport au trou de contact électrique, et ce grâce à la région 22a du matériau de remplissage 22 remplissant ce trou de contact, d'assurer un bon contact électrique sur toute la surface du trou de contact.

Par ailleurs, ce procédé permet un autoalignement de la ligne d'interconnexion sur le trou de contact électrique, c'est-à-dire qu'il permet d'éviter tout débordement inutile, en dehors du trou de contact, de la ligne d'interconnexion et donc d'augmenter la densité d'intégration des circuits intégrés de façon sensible, par rapport aux différents procédés connus.

La description donnée ci-dessus du procédé d'autopositionnement de l'invention n'est bien entendu, donnée qu'à titre d'exemple. En particulier, il est possible d'employer d'autres techniques de dépôt et de gravure, que celles décrites, des différentes couches de matériau utilisées dans le procédé de l'invention, ainsi que d'autres matériaux que ceux décrits pour constituer ces différentes couches.

## Revendications

1. Procédé d'autopositionnement d'une ligne d'interconnexion sur un trou de contact électrique d'un circuit intégré, caractérisé en ce que, le trou de contact électrique (17) étant réalisé dans une couche isolante (18), on effectue les opérations successives suivantes:

(a) - dépôt sur l'ensemble du circuit intégré d'une première couche conductrice (20),

(b) - dépôt sur la première couche conductrice (20), d'un matériau de remplissage (22) servant à combler le trou de contact (17), la surface (23) de ce matériau de remplissage (22) étant sensiblement plane,

(c) - réalisation d'une gravure anisotrope du matériau de remplissage (22) de façon à mettre à nu les parties (20a) de la première couche conductrice (20) situées en dehors du trou de contact (17) et à ne garder de ce matériau de remplissage (22) que la partie (22a) remplissant le trou de contact (17),

(d) - dépôt sur la structure obtenue d'une deuxième couche conductrice (26), dans laquelle sera réalisée la ligne d'interconnexion (26a),

(e) - réalisation sur la deuxième couche conductrice (26) d'un masque de résine (28) servant à définir les dimensions de la ligne d'interconnexion (26a),

(f) - élimination des parties de la deuxième couche conductrice (22) et de la première couche conductrice (20) dépourvues de masque (28), afin de réaliser la ligne d'interconnexion (26a), et

(g) - élimination du masque (28).

2. Procédé selon la revendication 1, caractérisé en ce que la première couche conductrice (20) est un film métallique assurant une barrière de diffusion entre la deuxième couche conductrice et les jonctions semi-conductrices sur lesquelles on réalise le contact électrique.

3. Procédé selon la revendication 2, caractérisé en ce que la première couche conductrice (20) est réalisée en un alliage de titane et de tungstène ou en tungstène.

4. Procédé selon l'une quelconque des revendications 1 à 3, caractérisé en ce que le matériau de remplissage (22) est réalisé en silicium polycristallin.

5. Procédé selon l'une quelconque des revendications 1 à 4, caractérisé en ce que l'on réalise le dépôt du matériau de remplissage (22) de façon isotrope.

6. Procédé selon l'une quelconque des revendications 1 à 5, caractérisé en ce que le matériau de remplissage (22) présente une épaisseur supérieure à la demi-largeur du trou de contact électrique (17).

7. Procédé selon l'une quelconque des revendications 1 à 6, caractérisé en ce que l'on réalise l'étape (C) en déposant une couche de résine (24) sur le matériau de remplissage (22) et en gravant simultanément la couche de résine (24) et le matériau de remplissage (22) avec des vitesses d'attaque identiques pour la résine et ledit matériau de remplissage.

8. Procédé selon l'une quelconque des revendications 1 à 7, caractérisé en ce que l'étape (f) est réalisée au moyen d'une gravure sèche anisotrope.

## Patentansprüche

1. Verfahren zur Selbstjustierung einer Verbindungsleitung über einem elektrischen Kontaktloch einer integrierten Schaltung, dadurch gekennzeichnet, daß man an dem elektrischen Kontaktloch (17), das in einer isolierenden Schicht (18) ausgebildet ist, die nachfolgenden Schritte aufeinanderfolgend ausführt:

(a) auf die gesamte integrierte Schaltung wird eine erste leitfähige Schicht (20) aufgebracht,

(b) auf die erste leitfähige Schicht (20) wird ein Füllmaterial (22) aufgebracht, das dazu dient, das Kontaktloch (17) zu füllen, wobei die Oberfläche (23) dieses Füllmaterials (22) im wesentlichen eben ist,

(c) das Füllmaterial (22) wird einer anisotropen Ätzung unterworfen derart, daß die Abschnitte (20a) der ersten leitfähigen Schicht (20), die außerhalb des Kontaktlochs (17) gelegen sind, freigelegt werden und von diesem Füllmaterial (22) nur der Abschnitt (22a) bedeckt bleibt, der das Kontaktloch (17) füllt,

(d) auf die erhaltene Struktur wird eine zweite leitfähige Schicht (26) aufgebracht, in der die Verbindungsleitung (26a) ausgebildet werden soll,

(e) auf die zweite leitfähige Schicht (26) wird eine Harzmaske (28) aufgebracht, die dazu dient, die Abmessungen der Verbindungsleitung (26a) festzulegen,

(f) diejenigen Abschnitte der zweiten leitfähigen Schicht (22) und der ersten leitfähigen Schicht (20), die nicht von der Maske (28) bedeckt sind, werden beseitigt, um die Verbindungsleitung (26a) auszubilden, und

(g) die Maske (28) wird beseitigt.

2. Verfahren nach Anspruch 1, dadurch gekennzeichnet, daß die erste leitfähige Schicht (20) ein Metallfilm ist, der eine Diffusionsbarriere zwischen der zweiten leitfähigen Schicht und den Halbleiterübergängen erzeugt, über denen man den elektrischen Kontakt herstellt.

3. Verfahren nach Anspruch 2, dadurch gekennzeichnet, daß die erste leitfähige Schicht (20) aus einer Titan- und Wolframlegierung oder aus Wolfram hergestellt ist.

4. Verfahren nach einem der Ansprüche 1 bis 3, dadurch gekennzeichnet, daß das Füllmaterial (22) aus polykristallinem Silicium besteht.

5. Verfahren nach einem der Ansprüche 1 bis 4, dadurch gekennzeichnet, daß man das Füllmaterial (22) in isotroper Weise aufbringt.

6. Verfahren nach einem der Ansprüche 1 bis 5, dadurch gekennzeichnet, daß das Füllmaterial (22) eine Dicke aufweist, die größer als die halbe Breite des elektrischen Kontaktlochs (17) ist.

7. Verfahren nach einem der Ansprüche 1 bis 6, dadurch gekennzeichnet, daß man den Schritt (C) dadurch ausführt, daß man eine Harzschicht (24) auf das Füllmaterial (22) aufbringt und man die Harzschicht (24) und das Füllmaterial (22) mit gleichen Geschwindigkeiten für das Harz und das Füllmaterial gleichzeitig ätzt.

8. Verfahren nach einem der Ansprüche 1 bis 7, dadurch gekennzeichnet, daß der Schritt (f) mittels trockener anisotroper Ätzung ausgeführt wird.


## Claims

1. Process for the autopositioning of an interconnection line on an electric contact hole of an integrated circuit, characterized in that, with the electric contact hole (17) formed in an insulating layer (18), the following successive operations are performed:

(a) deposition of a first conductive coating (20) on the complete integrated circuit,

(b) deposition of the first conductive coating (20) of a filling material (22) used for filling the contact hole (17), the surface (23) of said material (22) being substantially planar,

(c) carrying out an anisotropic etching of the filling material (22), so as to expose those parts (20a) of the first conductive coating (20) located outside the contact hole (17), and whilst retaining only that filling material (22) portion (22a) which fills the contact hole (17),

(d) deposition on the structure obtained of a second conductive coating (26), in which the interconnection line (26a) will be formed,

(e) formation on the second conductive coating (26) of a resin mask (28) used for defining the dimensions of the interconnection line (26a),

(f) elimination of those parts of the second (22) and first (20) conductive coatings which are free from the mask (28), in order to form the interconnection line (26a),

(g) elimination of the mask (28).

2. Process according to claim 1, characterized in that the first conductive coating (20) is a metallic film ensuring a diffusion barrier between the second conductive coating and the semiconducting junctions on which the electric contact is formed.

3. Process according to claim 2, characterized in that the first conductive coating (20) is made from an alloy of titanium or tungsten, or of tungsten alone.

4. Process according to any one of the claims 1 to 3, characterized in that the filling material (22) is of polycrystalline silicon.

5. Process according to any one of the claims 1 to 4, characterized in that the filling material (22) is isotropically deposited.

6. Process according to any one of the claims 1 to 5, characterized in that the filling material (22) is a thickness greater than half the width of the electric contact hole (17).

7. Process according to any one of the claims 1 to 6, characterized in that stage (c) is performed by depositing a resin layer (24) on the filling material (22) and by simultaneously etching the resin layer (24) and the filling material (22) at identical etching speeds for both the resin and the filling material.

8. Process according to any one of the claims 1 to 7, characterized in that (f) is performed by means of dry anisotropic etching.

**FIG. 1**

**FIG. 2**

1

FIG. 3

FIG. 4

FIG. 5

FIG. 6

FIG. 7

24
22
20
18
16

17    14

FIG. 8

20a    22    22a    20a

18

17    14

26    28

FIG. 9

20

18

16

17    22a

20a

30    26a

18

16    17    22a    14

FIG. 10

5